(19) Europäisches Patentamt
European Patent Office
Office européen des brevets

(11) **EP 2 006 696 A1**

(12) **EUROPEAN PATENT APPLICATION**

(43) Date of publication:
**24.12.2008 Bulletin 2008/52**

(51) Int Cl.:
*G01R 31/317* (2006.01)　　*H01L 23/50* (2006.01)

(21) Application number: **07290764.5**

(22) Date of filing: **20.06.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **NXP B.V.**
**5656 AG Eindhoven (NL)**

(72) Inventor: **The designation of the inventor has not yet been filed**

(74) Representative: **White, Andrew Gordon et al**
**NXP Semiconductors UK Ltd**
**Betchworth House**
**Station Road**
**Redhill**
**Surrey RH1 1DL (GB)**

(54) **Testable integrated circuit and test method**

(57) An integrated circuit (100) is disclosed comprising a plurality of circuit portions (130), each of the circuit portions having an internal supply rail (170) coupled to a global supply rail (160) via a cluster (140) of switches (152; 154) coupled in parallel between the internal supply rail (170) and the global supply rail (160). Each cluster (140) of switches (152; 154) has a first switch (152) having a first size and a second switch (154) having a second size, a fault-free first switch (152) having a higher resistance than a fault-free second switch (154). The IC (100) further comprises a test arrangement for testing the respective clusters (140) of switches (152; 154) in a test mode. The test arrangement comprises a test control input; a test output coupled to the respective internal supply rails (170) and control means (110, 114, 116) coupled to the test control input for enabling a selected cluster (140) of switches (152; 154) in the test mode. The control means comprise first selection means (114) for selectively enabling the first switch (152) and second selection means (116) for selectively enabling the second switch (154) of the selected cluster (140) in the test mode. This arrangement allows for the accurate measurement of the resistance of power switches (152; 154) between a global power rail (160) and an internal power rail (170) of a circuit portion (130), thus facilitating the detection of both resistive and stuck-at faults in these switches (152; 154).

Fig. 1

**Description**

The present invention relates to an integrated circuit (IC) comprising a plurality of circuit portions, each of the circuit portions having an internal supply rail coupled to a global supply rail via a cluster of switches coupled in parallel between the internal supply rail and global supply rail and a power supply input coupled to the global supply rail.

The present invention further relates to a method for testing such an IC.

The ongoing progress in the fields of IC design and manufacturing has led to the manufacture of very large scale integration (VLSI) ICs that are capable of implementing a plethora of different functions and comprise millions of components such as transistors, which may be organized into different circuit portions each implementing at least a part of a dedicated function of the IC. Such ICs tend to consume significant amounts of power, which may lead to a number of problems. For instance, the power demand of the various circuit portions may exceed the capacity of the power supply or power supply conductors at peak consumption, leading to a drop in the supply voltage. This jeopardizes the correct functioning of the IC. Another problem is that for ICs that are powered by a finite power source such as a battery, the operational lifetime of the power source is rather limited if the power demands of the IC are excessive.

To this end, such ICs typically comprise multiple power domains, in which a circuit portion has an internal supply rail coupled to a global supply rail via a number of power switches. The switches allow for the circuit portion to be powered down in an idle mode, which reduces the overall power consumption of the IC, thus mitigating the aforementioned problems.

to ensure the correct operation of an IC upon its manufacture, the IC has to be tested. In case of the presence of the aforementioned power switches, this includes the testing of these switches. Unpublished PCT application PCT/IB2007/050036 filed in the name of Koninklijke Philips Electronics N.V. and assigned to the applicant of the present application discloses an IC according to the opening paragraph in which a node between a power switch and its circuit portion is coupled to a two-input comparator arranged to receive a reference signal on its other input. The power switch can be activated in a test mode by a test controller. Consequently, by providing an appropriate reference signal, a stuck-at or resistive fault in the power switch can be detected.

A drawback of this approach is that the on-chip comparator may not reach the required levels of accuracy to detect certain resistive defects in such switches. Moreover, this approach does not take into consideration that the clusters of power switches may have a first switch having a first size and a second switch having a second size, with a fault-free first switch having a higher resistance than a fault-free second switch. The first size high-resistive switch is enabled in a first stage of the power-up of a circuit portion to avoid rapid ramp-up of the circuit portion voltage (which can cause the occurrence of an unwanted spike in the power supply), whereas the second size low-resistive switch is used to complete the power-up of the circuit portion upon completion of the first stage. Such clusters are becoming increasingly common in present ICs.

The present invention seeks to provide an IC having a test arrangement that allows the accurate testing of clusters of switches comprising a first switch having a first size and a second switch having a second size, a fault-free first switch having a higher resistance than a fault-free second switch.

The present invention further seeks to provide a method for testing such an IC.

According to an aspect of the present invention, the IC of the present invention has a test arrangement for testing the respective clusters of switches in a test mode of the integrated circuit, the test arrangement comprising a test control input; a test output coupled to the respective internal supply rails; control means coupled to the test control input for enabling a selected cluster of switches in the test mode, the control means comprising first selection means for selectively enabling the first switch and second selection means for selectively enabling the second switch of the selected cluster in the test mode.

This test arrangement facilitates separate off-chip measurement of the resistive values of both types of switches in the clusters of switches for powering up a circuit portion of the IC of the present invention, thus allowing for the accurate measurement of these values for both types of switches.

Preferably, the control means comprise a shift register for receiving test configuration data from the test control input; the first selection means comprise a first multiplexer for coupling the first switch to the shift register in the test mode; and the second selection means comprise a second multiplexer for coupling the second size switch to the shift register in the test mode, the control means further comprising a test control block for controlling the first and second multiplexers. This is a simple test control arrangement requiring little area overhead and few extra pins. In fact, the shift register may be integrated in a test access port (TAP) arrangement such as a boundary scan arrangement, in which case the shift register may use the TAP test data input (TDI).

In an embodiment, the IC of the present invention further comprises an analog-to-digital converter (ADC) coupled between the respective internal supply rails and the test output. This has the advantage that the resistance value of the switches under test can be made available in a digital form on the test output.

According to a further aspect of the invention, there is provided a method of testing an integrated circuit according to the present invention, the method comprising:

a) bringing the integrated circuit in a test mode;
b) selecting a cluster of switches;
c) enabling the first switch of the selected cluster;
d) providing a fixed current to the global power supply;
e) measuring a first voltage on the test output;
f) enabling the second switch of the selected cluster; and
g) measuring a second voltage on the test output.

This allows for the accurate determination of the resistive values of both types of switches.

Preferably, the step of enabling the first switch of the selected cluster is preceded by disabling the cluster of switches; and measuring an initial voltage on the test output. This way, the influence of the parasitic voltage of the power grid of the IC can be filtered out when determining the resistive value of the switch under test. It will be appreciated that the measurement of this parasitic voltage may be performed prior to a measurement of the resistive value of any switch, e.g. prior to step g) as well.

In an embodiment, measuring the first voltage is delayed until the circuit portion of the selected cluster has reached a steady state. This avoids the currents drawn by the circuit portion during its power-up to affect the measurement of the resistance of the switch under test. The steady state may be reached passively by waiting after a switch has been enabled, or actively by precharging the test output prior to enabling said switch.

In another embodiment, the step of enabling the second switch is preceded the step of by disabling the first switch. The measurement of the second switch in isolation has the advantage that a more accurate measurement of the resistive value of this switch may be obtained.

The invention is described in more detail and by way of non-limiting examples with reference to the accompanying drawings, wherein:

Fig.1 shows an aspect of an IC of the present invention;
Fig. 2 shows another aspect of an IC of the present invention; and
Fig. 3 shows a flowchart of the method of the present invention.

It should be understood that the Figures are merely schematic and are not drawn to scale. It should also be understood that the same reference numerals are used throughout the Figures to indicate the same or similar parts.

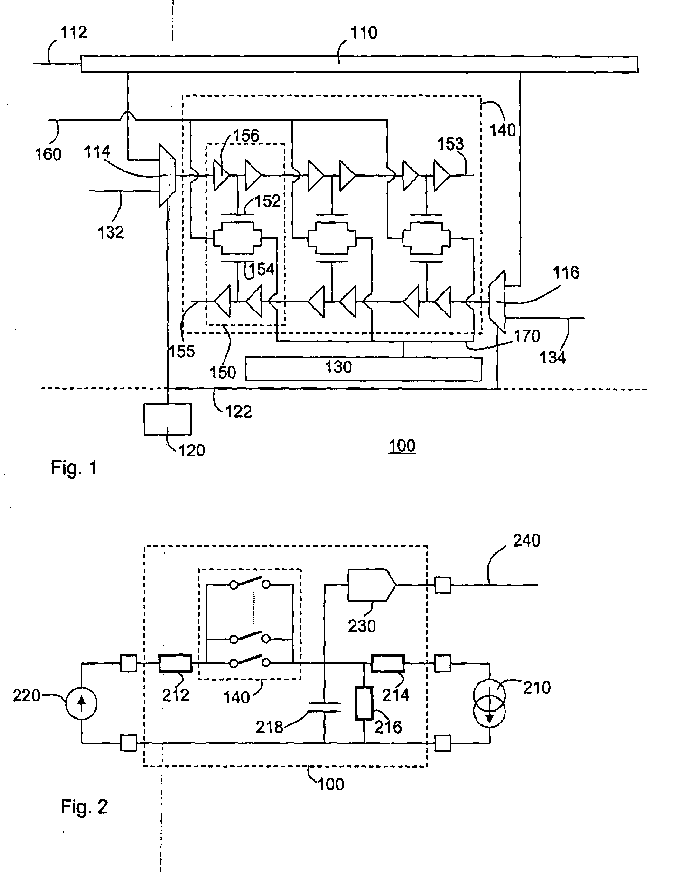

In Fig. 1, a part of an IC 100 according to the present invention is shown. A circuit portion 130 has an internal power rail 170, which is coupled to a global power rail 160 via a cluster 140 of first size switches 152 and second size switches 154. In the embodiment shown in Fig. 1, the cluster 140 has three domains 150, each comprising a first size switch 152 and a second size switch 154. The first size switch 152 has a larger resistance than the second size switch 154 to facilitate the gradual power-up of the circuit portion 130. During power-up, the first switch 152 is first enabled to allow the circuit portion 130 to reach a certain voltage level, e.g. $V_{dd}/3$, after which the second size switch is enabled to complete the power-up of the circuit portion 130. The gradual power-up avoids the drawing of excessive currents from the global supply line 160, thus avoiding the potential occurrence of spikes or dips in the power supply of the IC 100.

The IC 100 of the present invention comprises a test arrangement including, per domain 140, a test point register 110, a first multiplexer 114, and a second multiplexer 116. The test arrangement further comprises a global test control block (TCB) 120 for switching the first multiplexers 114 and the second multiplexers 116 in the various domains 140 to a test mode in which the inputs of the respective multiplexers are connected to the test point register 110. In functional mode, the selected input of the first multiplexer 114 is connected to control , line 132 and the selected input of the second multiplexer 116 is connected to control line 134. Control lines 132 and 134 are driven by the power management logic (not shown) of the IC 100 in functional mode.

The control terminals of the first size switches 152 are connected to an enable line 153 comprising buffer elements 156, and the control terminals of the second size switches 154 are connected to an enable line 155 comprising buffer elements 156. The buffer elements 156 ensure that the enable signal carried on the respective enable lines 153 and 155 maintains its intended shape, and ensure that a delay is introduced between enabling or disabling an upstream domain and a downstream domain. The introduction of the delay ensures that not too many switches of the same size become enabled at the same time. This avoids the drawing of excessive currents from the global supply rail 160.

It will be appreciated that the number of transistors per switch 152, 154 may be varied without departing from the present invention. The number of parallel transistors in a single switch will be governed by the technology scale in which the IC 100 is realized. In case a switch 152, 154 comprises more than a single transistor, the test point register 110 may be configured to individually control each transistor of such a switch. Similarly, the cluster 140 may have a single domain 150, in which case the buffer elements 156 may be omitted, or may have a different number of domains 150 than the three domains 150 shown in Fig. 1 without departing from the present invention. Also, the IC 100 typically will have more than a single circuit portion 130; Fig. 1 shows a single circuit portion 130 for the sake of clarity only. It is pointed out that not all of the additional circuit portions (not shown) need to be arranged so that they can be powered down; some of the additional circuit portions may be permanently powered up, i.e. directly connected to the global supply line 160.

In Fig. 1, a test point register 110 is shown. This shift register may be a part of a (boundary scan compliant) TAP. Similarly, the test control block 120 may be a part of the TAP controller of such a TAP. It will be appreciated that although the embodiment shown in Fig. 1 is a preferred embodiment because of the small area overhead and limited number of IC pins required in the test mode, other arrangements for the individual selection of clusters 140 and the control of the multiplexers 114, 116 are equally feasible.

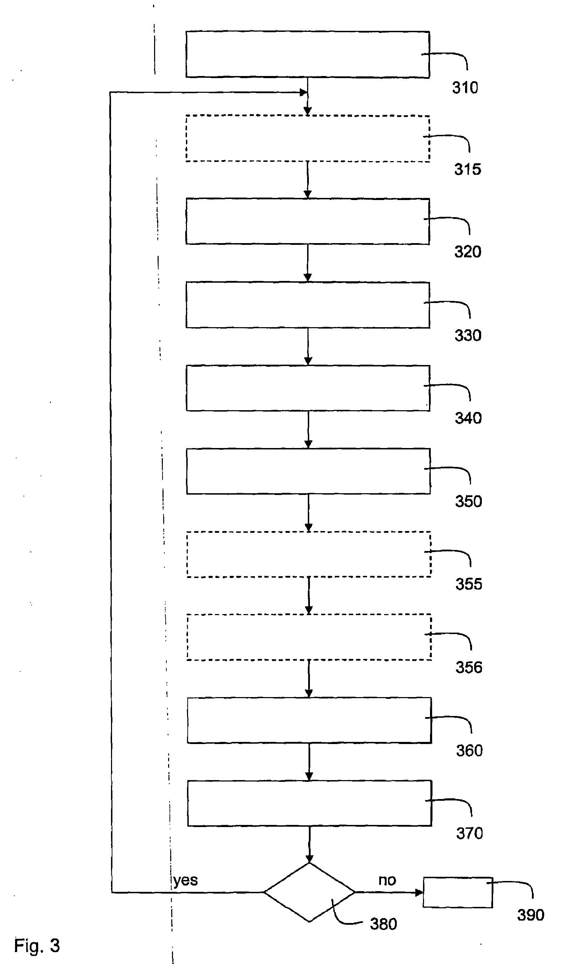

The operation of the test arrangement of IC 100 will now be explained with the aid of Fig. 3. In a first step 310, the IC 100 is switched to a test mode. The TCB 120 is activated e.g. by means of an externally provided test select signal, which causes the first multiplexer 114 and the second multiplexer 116 in each cluster 140 to switch from its functional input to the input connected to the test point register 110. It will be appreciated that the TCB 120 may also be configured to select multiplexers individually, although this requires a more complex TCB 120 and more complex wiring between the TCB 120 and the various multiplexers in the enable lines of the domains 140.

Next, an optional step 315 may take place in which the voltage drop is measured over the IC 100 without any first size switch 152 or any second size switch 154 enabled. This measurement enables the determination of the resistance $R_{off}$ of the IC 100 with all aforementioned switches and associated circuit portions 130 switched off.

In step 320, a cluster 140 of first size switches 152 and second size switches 154 is selected. This may be done by feeding an appropriate bit pattern into test point register 110 via a conductor 112 between a test data input (not shown) and the test point register 110. Steps 315 and 320 may be interchanged. In a next step 330, the first size switches 152 of the selected cluster are enabled. This may for instance be done by making the contents of the test point register 110 available on its outputs.

In step 340, a fixed current is provided to a power supply input of the IC 100 such that the resistance of the switches selected in step 330 can be accurately determined. An optional step 345 may be performed, in which the circuit portion 130 that is controlled by the enabled first size switch 152 is brought into a well-defined steady state to ensure that the testing of the first size switch 152 is not obscured by variations in the current drawn by its circuit portion 130.

In step 350, a first voltage is measured on the test output (not shown) of the IC 100. The first voltage reflects the voltage drop caused by the fixed current flowing through the enabled first size switch 152, thus allowing the determination of the resistance of the first size switch 152. This voltage may be measured directly by sensing the voltage on an analog test output, or may be measured in a digital form by making the first voltage available on an input of an analog-to-digital converter (ADC) 230 (see Fig. 2), with the output of the ADC 230 made available on a test output of the IC 100. It will be appreciated that rather than performing the test measurement in the voltage domain, the measurement may also be performed in the current domain by measuring a drop in the current against a fixed voltage for determining the resistance of a switch under test.

In a next step 360, the second size switches 154 of the selected cluster 140 are enabled and a second voltage is measured on the test output in step 370. The second voltage is indicative of the resistance of the second size switch under test. Step 360 may be preceded by an optional step 355 in which the first size switches 152 are disabled prior to enabling the second size switches 154 of the cluster 140 under test and another optional step 356 in which the voltage drop of the IC 100 without any switches 152 or 154 enabled to determine $R_{off}$ of the IC 100 again. The latter may be necessary if the steady state of the IC 100 has changed due to the testing of first size switches 152 in the previous steps. In step 380 it is checked if other clusters 140 need testing. If so, the method returns to step 315 or 320 and is repeated until there are no more clusters 140 to test, after which the method terminates in step 390.

The theory behind the various implementations of the method of the present invention is explained in more detail below. The principle of the method is based on determining the resistance $R_{on}$ of an enabled switch or group of switches in case of a cluster 140 having multiple domains 150. This is done by measuring the supply voltage $V_{dd}$ of the IC 100 with all first size switches 152 and second size switches 154 disabled and measuring the effective supply voltage $V_{ddSwitch}$ when the switch or switches under test are enabled:

$$R_{on} = \frac{V_{dd} - V_{ddSwitch}}{I_0} \qquad (1)$$

wherein $I_0$ is the constant current provided to the global supply rail 160. This measurement may be performed for first size switches 152 and second size switches 154 in isolation.

A more elaborate way of determining the resistance of a multi-transistor switch 152, 154 is by way of a differential measurement, in which the parasitic resistances of the power supply rails are filtered out. In the following, the integer variable N is defined as the number of switches in a cluster 140, and integer variable n is defined as the number of transistors activated per switch. In a first configuration, a single transistor of a switch under test is enabled (n = 1). Now, $R_{on}$ may be defined as follows:

$$R_{on} = \frac{R_t}{N} \qquad (2)$$

wherein $R_t$ is the resistance of the enabled transistor.

In a first measurement $V_{DPS1}$, $V_{dd}$ is measured, and in a second measurement $V_{DPS2}$, the effective $V_{ddSwitch1}$ is measured for the enabled single transistor. This yields:

$$V_{DPS1} - V_{DPS2} = \Delta V_{DPS(1)} = \left( R_{rail1} + R_{rail2} + \frac{R_t}{N} \right) * I_0 \qquad (3)$$

wherein $R_{rail1}$ is the resistance of the global power rail 160 and $R_{rail2}$ is the resistance of the internal power rail 170.

In a second configuration, all n transistors of the switch under test are enabled. Now, $R_{on}$ may be defined as follows:

$$R_{on} = \frac{R_t}{n * N} \qquad (4)$$

The first and second measurements are repeated for the second configuration. This yields:

$$V_{DPS1} - V_{DPS2} = \Delta V_{DPS(2)} = \left( R_{rail1} + R_{rail2} + \frac{R_t}{n * N} \right) * n * I_0 \qquad (5)$$

Note that $I_0$ has been modified to $n*I_0$ to ensure that the constant current running through the n transistors is the same as the constant current running through the single transistor in the first switch configuration. The following subtraction may be performed:

$$n * \Delta V_{DPS(1)} - \Delta V_{DPS(2)} = \frac{R_t}{N} * (n-1) * I_0 \qquad (6)$$

This yields:

$$R_t = \frac{n * \Delta V_{DPS(1)} - \Delta V_{DPS(2)}}{I_0} * \frac{N}{(n-1)} \qquad (7)$$

This approach has the advantage that the influence of the parasitic resistances of the power rails, i.e. $R_{rail1}$ and $R_{rail2}$, has been filtered out of the measurement of the resistance of transistor in the switch under test, thus yielding a more accurate measurement of its resistance. It will be appreciated that this differential measuring method can be applied to each individual transistor of the switch under test.

Figure 2 shows a part of the IC 100 of the present invention in combination with a part of automated test equipment (ATE). In IC 100, resistor 212 is a conceptual representation of $R_{rail1}$, and resistor 214 is a conceptual representation of $R_{rail2}$. Resistor 216 is a conceptual representation of $R_t$, which capacitor 218 being a conceptual representation of the capacitance of the switch under test. The IC 100 under test is coupled to a power supply source 210 and a current source 220 that draws a fixed current $I_0$ from the IC 100. As mentioned earlier, $V_{ddSwitch}$ may be measured in a number of ways. The voltage variation in supply source 210 may be measured. Alternatively, the IC 100 may comprise an ADC 230 coupled to a digital output, which is coupled to a digital bus 240 of the ATE for providing a measurement of $V_{ddSwitch}$ in a digital form. ADC 230 may be added to the IC 100 for test purposes only, or may be an ADC that is also used by the IC 100 in its functional mode. This arrangement allows for the accurate measurement of the resistance of power switches between a global power rail 160 and an internal power rail 170 of a circuit portion 130, thus facilitating the detection of both resistive and stuck-at faults in these switches.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to an advantage.

**Claims**

1. An integrated circuit (100) comprising:

   a plurality of circuit portions (130), each of the circuit portions having an internal supply rail (170) coupled to a global supply rail (160) via a cluster (140) of switches (152; 154) coupled in parallel between the internal supply rail (170) and the global supply rail (160), each cluster (140) of switches (152; 154) comprising a first switch (152) having a first size and a second switch (154) having a second size, a fault-free first switch (152) having a higher resistance than a fault-free second switch (154); and
   a test arrangement for testing the respective clusters (140) of switches (152; 154) in a test mode of the integrated circuit (100), the test arrangement comprising:

   a test control input;
   a test output coupled to the respective internal supply rails (170);
   control means (110, 114, 116) coupled to the test control input for enabling a selected cluster (140) of switches (152; 154) in the test mode, the control means comprising first selection means (114) for selectively enabling the first switch (152) and second selection means (116) for selectively enabling the second switch (154) of the selected cluster (140) in the test mode.

2. An integrated circuit (100) as claimed in claim 1, wherein:

   the control means comprise a shift register (110) for receiving test configuration data from the test control input;
   the first selection means comprise a first multiplexer (114) for coupling the first switch (152) to the shift register (110) in the test mode; and
   the second selection means comprise a second multiplexer (120) for coupling the second switch (154) to the shift register (110) in the test mode, the control means further comprising a test control block (120) for controlling the first and second multiplexers (114; 116).

3. An integrated circuit (100) as claimed in claim 1 or 2, further comprising an analog-to-digital converter (230) coupled between the respective internal supply rails (170) and the test output.

4. An integrated circuit (100) as claimed in any of claim 1-3, wherein:

   each cluster (140) of switches (152; 154) comprises a plurality of domains (150), each domain (150) comprising at least one of said first switch (152) and at least one of said second switch (154);
   the control terminals of the first switches (152) of the respective domains (150) are coupled to a first enable line (153), the first enable line (153) comprising delay elements (156) for delaying the propagation of a first enable signal from an upstream domain (150) to a downstream domain (150); and
   the control terminals of the second switches (154) of the respective domains (150) are coupled to a second enable line (155), the second enable line (155) comprising delay elements (156) for delaying the propagation of a second enable signal from an upstream domain (150) to a downstream domain (150).

**5.** A method of testing an integrated circuit (100) comprising a plurality of circuit portions (130), each of the circuit portions having an internal supply rail (170) coupled to a global supply rail (160) via a cluster (140) of switches (152; 154), each cluster (140) of switches (152; 154) comprising a first switch (152) having a first size and a second switch (154) having a second size, a fault-free first switch (152) having a higher resistance than a fault-free second switch (154) and a test output coupled to the respective internal supply rails (170), the method comprising:

   a) bringing (310) the integrated circuit (100) in a test mode;
   b) selecting (330) a cluster (140) of switches (152; 154);
   c) enabling (340) the first switch (152) of the selected cluster (140);
   d) providing (320) a fixed current to the global supply rail (160);
   e) measuring (350) a first voltage on the test output;
   f) enabling (360) the second switch (154) of the selected cluster (140); and
   g) measuring (370) a second voltage on the test output.

**6.** A method as claimed in claim 5, wherein the step of enabling the first switch of the selected cluster is preceded by measuring (325) an initial voltage on the test output.

**7.** A method as claimed in claim 5 or 6, further comprising delaying measuring the first voltage until the circuit portion (130) of the selected cluster (140) has reached a steady state.

**8.** A method as claimed in claim 5, 6 or 7, further comprising delaying measuring the second voltage until the circuit portion (130) of the selected cluster (140) has reached a steady state.

**9.** A method as claimed in any of claims 5 - 8 wherein the step of enabling the second switch (154) is preceded by the step of disabling (355) the first switch (152).

**10.** A method as claimed in claim 5 or 6, further comprising selecting a further cluster of switches and repeating steps d) - g) for the further cluster.

Fig. 1

Fig. 2

Fig. 3

**European Patent Office**

**EUROPEAN SEARCH REPORT**

Application Number

EP 07 29 0764

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 612 920 A (TOMISHIMA SHIGEKI [JP]) 18 March 1997 (1997-03-18) * abstract; claims 1-11; figures 1-12 * * column 1, lines 11-17 * * column 2, line 37 - column 3, line 45 * ----- | 1-10 | INV. G01R31/317 H01L23/50 |
| A | US 2002/054532 A1 (OOISHI TSUKASA [JP] ET AL) 9 May 2002 (2002-05-09) * abstract; claims 1-16; figures 1-20 * * paragraphs [0009] - [0032] * * paragraphs [0075] - [0113] * * paragraphs [0135] - [0144] * ----- | 1-10 | |
| A | EP 0 899 740 A (NIPPON ELECTRIC CO [JP]) 3 March 1999 (1999-03-03) * abstract; claims 1-12; figures 1-9 * * paragraphs [0038] - [0056] * * paragraphs [0077] - [0098] * ----- | 1-10 | |
| A | US 5 592 423 A (TOKAMI KENJI [JP]) 7 January 1997 (1997-01-07) * abstract; claims 1-10; figures 1-17 * * column 5, line 23 - column 6, line 40 * ----- | 1-10 | TECHNICAL FIELDS SEARCHED (IPC) G01R H01L |

The present search report has been drawn up for all claims

| Place of search | Date of completion of the search | Examiner |
|---|---|---|
| Munich | 23 November 2007 | Nadal, Rafael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 07 29 0764

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2007

| Patent document cited in search report | | Publication date | Patent family member(s) | | Publication date |
|---|---|---|---|---|---|
| US 5612920 | A | 18-03-1997 | JP | 8153388 A | 11-06-1996 |
| US 2002054532 | A1 | 09-05-2002 | NONE | | |
| EP 0899740 | A | 03-03-1999 | CN | 1213143 A | 07-04-1999 |
| | | | JP | 3087839 B2 | 11-09-2000 |
| | | | JP | 11073800 A | 16-03-1999 |
| | | | TW | 451122 B | 21-08-2001 |
| | | | US | 5942808 A | 24-08-1999 |
| US 5592423 | A | 07-01-1997 | JP | 3583482 B2 | 04-11-2004 |
| | | | JP | 8106799 A | 23-04-1996 |

EPO FORM P0459

For more details about this annex : see Official Journal of the European Patent Office, No. 12/82

**EP 2 006 696 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO IB2007050036 W